# EUROPEAN PATENT SPECIFICATION

(11) **EP 4 485 484 B1**
(45) Date of publication and mention of the grant of the patent: **18.11.2026**
(21) Application number: 23903166.9
(22) Date of filing: 10.11.2023
(51) Int. Cl.: H01B 12/06, H10N 60/20, H10N 60/85

(54) **SUPERCONDUCTING WIRE**
SUPRALEITENDER DRAHT
FIL SUPRACONDUCTEUR

(30) Priority: 13.12.2022 JP 2022198562
(43) Date of publication of application: 01.01.2025
(73) Proprietor: SUMITOMO ELECTRIC INDUSTRIES, LTD., Osaka-shi, Osaka 541-0041 (JP)
(72) Inventor: NAGAISHI, Tatsuoki, Osaka-shi, Osaka 541-0041 (JP); INAGAKI, Makoto, Osaka-shi, Osaka 541-0041 (JP); YOSHIHARA, Tatsuhiko, Osaka-shi, Osaka 541-0041 (JP); HONDA, Genki, Osaka-shi, Osaka 541-0041 (JP); KOBAYASHI, Shinichi, Osaka-shi, Osaka 541-0041 (JP)
(74) Representative: Grünecker Patent- und Rechtsanwälte PartG mbB
(86) International application number: PCT/JP2023/040541
(87) International publication number: WO 2024/127868

(56) References cited:
- WO-A1-2017/060968
- WO-A1-2017/060968
- WO-A1-2018/163501
- WO-A1-2018/211764
- WO-A1-2018/211766
- US-A1- 2008 176 749
- US-A1- 2013 331 272
- US-A1- 2019 318 849

## Description

### TECHNICAL FIELD

The present disclosure relates to a superconductive wire. The present application claims the benefit of priority to Japanese Patent Application No. 2022-198562 filed on December 13, 2022.

### BACKGROUND ART

For example, WO 2017/217487 A1 (PTL 1) describes a superconductive wire. The superconductive wire described in PTL 1 includes a substrate, an intermediate layer, a superconductive layer, and a plurality of artificial pin rods.

The substrate has a first main surface. The intermediate layer has a second main surface and a third main surface opposite to the second main surface. The intermediate layer is disposed on the substrate in such a manner that the second main surface faces the first main surface. The superconductive layer is disposed on the third main surface. The plurality of artificial pin rods are dispersed in the superconductive layer.

The constituent material of the superconductive layer is REBa₂Cu₃Oₓ (RE is a rare earth element). The constituent material of each of the plurality of artificial pin rods is RE₂O₃ or BaMO₃ (M is a tetravalent metal element). The c-axis direction of the superconductive layer is along the normal direction of the third main surface. The longitudinal direction of the artificial pin rod is along the c-axis direction of the superconductive layer.

### CITATION LIST

### PATENT LITERATURE

PTL 1: WO 2017/217487 A1
US 2013/331272 A1 discloses a superconducting tape structure comprising a substrate, a buffer layer disposed on the substrate, and a superconducting layer. The superconducting layer exhibits a critical current retention factor greater than about 90% when subjected to a magnetic field of approximately 0.1 T applied substantially parallel US 2008/176749 A1 relates to high-performance superconducting devices employing epitaxial, preferentially oriented nanodots and/or nanorods. It describes a flexible, polycrystalline, REBCO-type high-temperature superconducting tape having a {100}〈100〉 or rotated {100}〈100〉 texture. The tape includes at least one superconducting layer in which crystalline, epitaxial columns of non-superconducting nanodots and/or nanorods are non-randomly dispersed and aligned along the c-axis of the superconductor. The nanodots/nanorods have diameters in the range of 2-100 nm. US 2019/318849 A1 concerns an oxide superconducting wire comprising a superconducting layer formed on a substrate. The superconducting layer includes artificial pinning rods of differing lengths, dispersed within a plane parallel to the substrate surface. The degree of length dispersion of the artificial pinning rods in this plane is at least 5 mm.

WO 2018/211764 A1 discloses a superconducting wire material formed by joining a first wire material having a first superconducting layer to a second wire material having a second superconducting layer. A superconducting joining layer connects overlapping portions of the two superconducting layers. Within this joining layer, a plurality of particles and/or voids, each serving as a pinning center, are dispersed.

### SUMMARY OF INVENTION

A superconductive wire of the present invention as defined in independent claim 1 includes a substrate, an intermediate layer, a superconductive layer, a plurality of first precipitates and a plurality of second precipitates. The substrate has a first main surface. The intermediate layer has a second main surface and a third main surface opposite to the second main surface, and is disposed on the substrate in such a manner that the second main surface faces the first main surface. The superconductive layer is disposed on the third main surface. The constituent material of the superconductive layer is REBa₂Cu₃Oₓ (RE is a rare earth element). The plurality of first precipitates and the plurality of second precipitates are dispersed in the superconductive layer. The constituent material of each of the plurality of first precipitates and the constituent material of each of the plurality of second precipitates is a non-superconductive material. In a cross-sectional view orthogonal to the third main surface, an aspect ratio of the width, W1, in the longitudinal direction and the width, W2, in the direction orthogonal to the longitudinal direction of each of the plurality of first precipitates is greater than 1. In the cross-sectional view, the longitudinal direction of each of the plurality of first precipitates forms an angle of 20° or less with respect to the third main surface. In the cross-sectional view, the plurality of second precipitates are aligned in a row to form a group. In the cross-sectional view, an alignment direction of the plurality of second precipitates in the group forms an angle of 20° or less with respect to the third main surface.

### BRIEF DESCRIPTION OF DRAWINGS

Fig. 1 is a cross-sectional view of a superconductive wire 100;
Fig. 2A is an enlarged view of a part in Fig. 1;
Fig. 2B is an enlarged view of a part in the vicinity of an end of a precipitate 40 in the longitudinal direction;
Fig. 3A is a first enlarged cross-sectional view of a superconductive wire 100 according to a first modification;
Fig. 3B is a second enlarged cross-sectional view of the superconductive wire 100 according to the first modification;
Fig. 4 is an enlarged cross-sectional view of a superconductive wire 100 according to a second modification;
Fig. 5 is an enlarged cross-sectional view of a superconductive wire 100 according to a third modification;
Fig. 6 is an enlarged cross-sectional view of a superconductive wire 100 according to a fourth modification;
Fig. 7 is an enlarged cross-sectional view of a superconductive wire 100 according to a fifth modification;
Fig. 8 is a process chart of manufacturing the superconductive wire 100;
Fig. 9 is a cross-sectional view illustrating a preparation step S1;
Fig. 10 is a cross-sectional view illustrating the intermediate layer forming step S2; and
Fig. 11 is a cross-sectional view illustrating a superconductive layer forming step S3.

### DETAILED DESCRIPTION

### [Problem to be Solved by the Present invention]

The superconductive wire described in PTL 1 has a room for improvement in low-temperature magnetic field property. The present invention has been made in view of the above-mentioned problem in the prior art.

More specifically, the present invention provides a superconductive wire with an improved low-temperature magnetic field property.

### [Advantageous Effect of the Present Disclosure]

According to the superconductive wire of the present invention, the low-temperature magnetic field property can be improved.

### [Description of Embodiments]

First, embodiments of the present invention will be described.

(1) A superconductive wire according to an embodiment includes a substrate, an intermediate layer, a superconductive layer, a plurality of first precipitates and a plurality of second precipitates. The substrate has a first main surface. The intermediate layer has a second main surface and a third main surface opposite to the second main surface, and is disposed on the substrate in such a manner that the second main surface faces the first main surface. The superconductive layer is disposed on the third main surface. The constituent material of the superconductive layer is REBa₂Cu₃Oₓ (RE is a rare earth element). The plurality of first precipitates and the plurality of second precipitates are dispersed in the superconductive layer. The constituent material of each of the plurality of first precipitates and the constituent material of each of the plurality of second precipitates is a non-superconductive material. In a cross-sectional view orthogonal to the third main surface, an aspect ratio of the width, W1, in the longitudinal direction and the width, W2, in the direction orthogonal to the longitudinal direction of each of the plurality of first precipitates is greater than 1. In the cross-sectional view, the longitudinal direction of each of the plurality of first precipitates forms an angle of 20° or less with respect to the third main surface. In the cross-sectional view, the plurality of second precipitates are aligned in a row to form a group. In the cross-sectional view, an alignment direction of the plurality of second precipitates in the group forms an angle of 20° or less with respect to the third main surface.
   According to the superconductive wire of the above (1), the low-temperature magnetic field property can be improved.
(2) In the superconductive wire of the above (1), the constituent material of each of the plurality of first precipitates may be metal oxide.
(3) In the superconductive wire of the above (1) or (2), the constituent material of each of the plurality of first precipitates may be RE₂O₃ or BaMO₃ (M is a tetravalent metal element).
(4) In the superconductive wire of the above (1) to (3), the average value of the aspect ratios of the plurality of first precipitates may be 2 or more.
(5) In the superconductive wire of the above (1) to (4), a third precipitate may be further dispersed in the superconductive layer. The constituent material of the third precipitate may be a non-superconductive material. In the cross-sectional view, the third precipitate may have a granular shape.
   According to the superconductive wire of the above (5), the low-temperature magnetic field property can be further improved.
(6) In the superconductive wire of the above (1) to (5), in the cross-sectional view, the maximum value of a spacing in the direction parallel to the third main surface between two adjacent precipitates of the plurality of first precipitates in the direction parallel to the third main surface may be 1500 nm or less.
   According to the superconductive wire of the above (6), the low-temperature magnetic field property can be further improved.
(7) In the superconductive wire of the above (1) to (6), in the cross-sectional view, the maximum value of a spacing in the direction orthogonal to the third main surface between two adjacent precipitates of the plurality of first precipitates in the direction orthogonal to the third main surface may be 500 nm or less.
   According to the superconductive wire of the above (7), the low-temperature magnetic field property can be further improved.
(8) In the superconductive wire of the above (1) to (7), in the cross-sectional view, the minimum value and the maximum value of a width in the longitudinal direction of each of the plurality of first precipitates may be 10 nm or more and 2000 nm or less, respectively.
   According to the superconductive wire of the above (8), the low-temperature magnetic field property can be further improved.
(9) In the superconductive wire of the above (1) to (8), in the cross-sectional view, the maximum value of the width in the direction orthogonal to the longitudinal direction of each of the plurality of first precipitates may be 200 nm or less.
   According to the superconductive wire of the above (9), the low-temperature magnetic field property can be further improved.
(10) In the superconductive wire of the above (1) to (9), in the cross-sectional view, at least one of the plurality of first precipitates may have, between both ends thereof in the longitudinal direction, a first protruding portion that protrudes along a direction orthogonal to the longitudinal direction. In the cross-sectional view, the group may have, between both ends thereof in the alignment direction, a second protruding portion that protrudes along a direction orthogonal to the alignment direction.
   According to the superconductive wire of the above (10), the low-temperature magnetic field property can be further improved.
(11) In the superconductive wire of the above (1) to (10), each of the plurality of first precipitates may a tip portion at an end in the longitudinal direction, and the width of the tip portion in a direction orthogonal to the longitudinal direction becomes smaller toward the end.

According to the superconductive wire of the above (11), the low-temperature magnetic field property can be further improved.

### [Details of Embodiments]

Next, embodiments of the present invention will be described in detail with reference to the drawings. In the following drawings, the same or corresponding parts are denoted by the same reference numerals, and the description thereof will not be repeated. The superconductive wire according to the embodiment is defined as a superconductive wire 100.

### <Configuration of Superconductive Wire 100>

Hereinafter, the configuration of a superconductive wire 100 will be described.

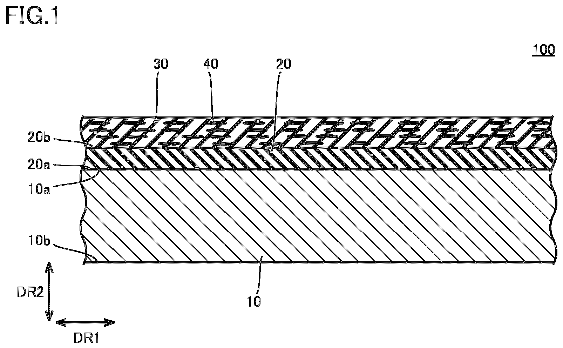

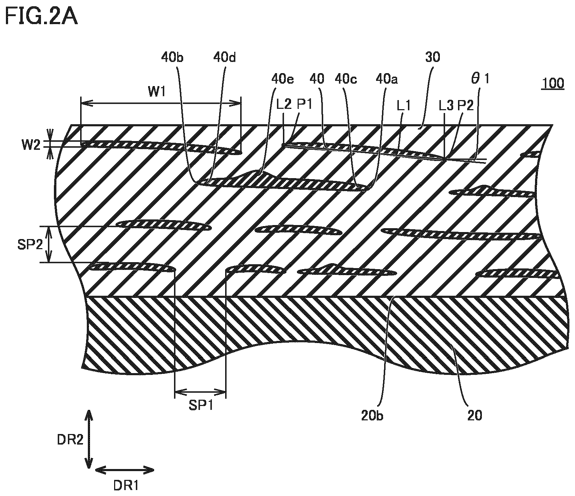

Fig. 1 is a cross-sectional view of the superconductive wire 100. Fig. 2A is an enlarged view of a part in Fig. 1. As illustrated in Figs. 1 and 2A, the superconductive wire 100 includes a substrate 10, an intermediate layer 20, a superconductive layer 30, and a plurality of precipitates 40.

The substrate 10 has a main surface 10a and a main surface 10b. The main surface 10a and the main surface 10b are end surfaces in the thickness direction of the substrate 10. The main surface 10b is opposite to the main surface 10a.

The substrate 10 is, for example, a cladding material composed of a tape member made of stainless steel, a copper (Cu) layer disposed on the tape member, and a nickel (Ni) layer disposed on the copper layer. In the copper layer, the copper crystal grains are crystal-oriented. Therefore, the nickel layer is also crystal-oriented along the crystal orientation of the copper layer. The nickel layer constitutes the main surface 10a. The substrate 10 may be made of Hastelloy (registered trademark). The substrate 10 may include a tape member made of a biaxially oriented metal material or a tape member made of a non-oriented metal material.

The intermediate layer 20 has a main surface 20a and a main surface 20b. The main surface 20a and the main surface 20b are end surfaces in the thickness direction of the intermediate layer 20. The main surface 20b is opposite to the main surface 20a. The intermediate layer 20 is disposed on the main surface 10a in such a manner that the main surface 20a faces the main surface 10a.

The intermediate layer 20 includes, for example, an yttrium oxide (Y₂O₃) layer, an yttria-stabilized zirconium oxide (YSZ) layer, and a cerium oxide (CeO₂) layer. The yttrium oxide layer is disposed on the main surface 10a. The yttria-stabilized zirconium oxide layer is disposed on the yttrium oxide layer. The cerium oxide layer is disposed on the yttria-stabilized zirconium oxide layer. The intermediate layer 20 may not include at least one of an yttria-stabilized zirconium oxide layer and a cerium oxide layer. As described above, since the nickel layer of the substrate 10 is crystal-oriented, each layer of the intermediate layer 20 is crystal-oriented along the crystal orientation of the nickel layer in the substrate 10. When the substrate 10 is made of Hastelloy (registered trademark), the intermediate layer 20 includes, for example, an aluminum oxide (Al₂O₃) layer, an yttrium oxide layer, a magnesium oxide (MgO) layer, a lanthanum manganite (LaMnO₃) layer, and a cerium oxide layer. In this case, the intermediate layer 20 may not include a cerium oxide layer.

The superconductive layer 30 is disposed on the intermediate layer 20 (on the main surface 20b). The superconductive layer 30 is made of a superconductive material. More specifically, the constituent material of the superconductive layer 30 is REBa₂Cu₃Oₓ (RE is a rare earth element). The rare earth element may be gadolinium (Gd), yttrium (Y), europium (Eu), holmium (Ho), ytterbium (Yb), samarium (Sm), dysprosium (Dy), or neodymium (Nd). The rare earth element is not limited thereto. Since the intermediate layer 20 is crystal-oriented as described above, the superconductive layer 30 is crystal-oriented along the crystal orientation of the intermediate layer 20. More specifically, superconductive layer 30 is crystal-oriented such that the c-axis direction of the superconductive layer 30 is along the normal direction of the main surface 20b.

Although not shown in the figures, the superconductive wire 100 may further include a protective layer and a stabilization layer. The constituent material of the protective layer is, for example, silver or a silver alloy, and the constituent material of the stabilization layer is copper or a copper alloy. The protective layer is disposed on the superconductive layer 30, and the stabilization layer is disposed on the protective layer.

The plurality of precipitates 40 are dispersed in the superconductive layer 30. The constituent material of the precipitate 40 is a non-superconductive material. The constituent material of the precipitate 40 is, for example, metal oxide. The constituent material of the precipitate 40 is, for example, RE₂O₃. The rare earth element contained in the constituent material of the precipitate 40 is, for example, the same as the rare earth element contained in the constituent material of the superconductive layer 30. The constituent material of the precipitate 40 may be BaMO₃ (M is a tetravalent metal element). The tetravalent metal element may be hafnium (Hf), zirconium (Zr), tin (Sn), titanium (Ti), or the like.

In the cross-sectional view, the width of the precipitate 40 in the longitudinal direction is defined as a width W1. The cross-sectional view refers to a view where the superconductive layer 30 is observed in an arbitrary cross section orthogonal to the main surface 20b. The longitudinal direction of the precipitate 40 is defined as a direction in which the width of the precipitate 40 is maximum. In the cross-sectional view, the width in a direction orthogonal to the longitudinal direction of the precipitate 40 is defined as a width W2. The width W1 is greater than the width W2.

In the cross-sectional view, an aspect ratio of the precipitate 40 is defined as value obtained by dividing the width W1 by the width W2. In the cross-sectional view, the aspect ratio of the precipitate 40 is greater than 1. The three-dimensional shape of the precipitate 40 may be a rod shape, a plate shape, or a disk shape. In the cross-sectional view, the average value of the aspect ratios of the plurality of precipitates 40 may be 2 or more, and may be 5 or more. In the cross-sectional view, the average value of the aspect ratios of the plurality of precipitates 40 is determined by the following method.

Firstly, a transmission electron microscope (TEM) is used to acquire a TEM image of the superconductive layer 30 in an arbitrary cross section of the superconductive layer 30 orthogonal to the main surface 20b. The TEM image is acquired at such a magnification (a first magnification) that at least 50 precipitates 40 are present in the field of view. Secondly, the aspect ratio of each of the plurality of precipitates 40 present in the field of view is determined by measuring the width W1 and the width W2 of each of the plurality of precipitates 40 present in the field of view. In measuring the width W1 and the width W2, the TEM image is magnified at a second magnification that is larger than the first magnification. Thirdly, a value obtained by dividing the sum of the aspect ratios of the plurality of precipitates 40 present in the observation field by the number of the plurality of precipitates 40 present in the observation field is defined as an average value of the aspect ratios of the plurality of precipitates 40 in the superconductive layer 30. The first magnification and the second magnification may be 50,000 times and 200,000 times, respectively.

The minimum value of the width W1 is, for example, 10 nm or more, 20 nm or more, or 40 nm or more. The maximum value of the width W1 is, for example, 2000 nm or less, 1800 nm or less, or 1500 nm or less. The minimum value of the width W2 is, for example, 1 nm or more, 4 nm or more, or 10 nm or more. The maximum value of the width W2 is, for example, 200 nm or less, 150 nm or less, or 80 nm or less. As illustrated in Fig. 2A, in a precipitate 40 having a tip portion 40c (or a tip portion 40d) with a smaller width W2, the width W2 is as close as possible to zero at the tip portion 40c (or the tip portion 40d).

The minimum value and the maximum value of the width W1 and the minimum value and the maximum value of the width W2 are determined by the following method. Firstly, a TEM is used to acquire a TEM image of the superconductive layer 30 in an arbitrary cross section of the superconductive layer 30 orthogonal to the main surface 20b. The TEM image is acquired at such a magnification (a first magnification) that at least 50 precipitates 40 are present in the field of view. Secondly, the width W1 is measured for each of the plurality of precipitates 40 present in the field of view. In measuring the width W1, the TEM image is magnified at a second magnification that is larger than the first magnification. Thirdly, the largest value of the measured widths W1 is defined as the maximum value of the width W1, and the smallest value of the measured widths W1 is defined as the minimum value of the width W1. The first magnification and the second magnification may be 50,000 times and 200,000 times, respectively. The minimum value and the maximum value of the width W2 are also determined by the same method.

A direction parallel to the main surface 20b in the cross-sectional view is defined as a first direction DR1, and a direction orthogonal to the main surface 20b in the cross-sectional view is defined as a second direction DR2. In the cross-sectional view, the plurality of precipitates 40 are aligned to form a plurality of rows along the first direction DR1. The rows of the precipitates 40 are aligned along the first direction DR1 even if the direction in which the precipitates 40 are aligned is not parallel to the first direction DR1. The rows of the plurality of precipitates 40 are aligned with a spacing in the second direction DR2.

A spacing in the first direction DR1 between two precipitates 40 adjacent to each other in the first direction DR1 is defined as a spacing SP1. A spacing in the second direction DR2 between two precipitates 40 adjacent to each other in the second direction DR2 is defined as a spacing SP2.

The maximum value of the spacing SP1 is, for example, 1500 nm or less, 1000 nm or less, or 500 nm or less. The minimum value of the spacing SP1 is, for example, 8 nm or more, 10 nm or more, or 15 nm or more. The maximum value of the spacing SP2 is, for example, 500 nm or less, 400 nm or less, or 300 nm or less. The minimum value of the spacing SP2 is, for example, 2 nm or more, 3 nm or more, or 15 nm or more.

The minimum value and the maximum value of the spacing SP1 and the minimum value and the maximum value of the spacing SP2 are determined by the following method. Firstly, a TEM is used to acquire a TEM image of the superconductive layer 30 in an arbitrary cross section of the superconductive layer 30 orthogonal to the main surface 20b. The TEM image is acquired at such a magnification (a first magnification) that at least 50 precipitates 40 are present in the field of view. Secondly, the spacing SP1 is measured for all of the plurality of precipitates 40 present in the field of view. In measuring the spacing SP1, the TEM image is magnified at a second magnification that is larger than the first magnification. Thirdly, the largest value of the measured spacing SP1 is defined as the maximum value of the spacing SP1 in the superconductive layer 30, and the smallest value of the measured spacing SP1 is defined as the minimum value of the spacing SP1. The first magnification and the second magnification may be 50,000 times and 200,000 times, respectively. The maximum value and the minimum value of the spacing SP2 are also determined by the same method.

An angle formed between the longitudinal direction of the precipitate 40 and the main surface 20b in the cross-sectional view is defined as an inclination angle θ1. The longitudinal direction of the precipitate 40 in the cross-sectional view is defined as the direction of a straight line L1 which is defined as follows. Firstly, a straight line L2 and a straight line L3 are drawn. The straight line L2 and the straight line L3 are orthogonal to the main surface 20b and sandwich the precipitate 40. An intersection point between the straight line L2 and the precipitate 40 is defined as an intersection point P1. An intersection point between the straight line L3 and the precipitate 40 is defined as an intersection point P2. The straight line L1 is drawn to pass through the intersection point P1 and the intersection point P2. The width W1 corresponds to the length of the straight line L1. The inclination angle θ1 is 20° or less. The inclination angle θ1 may be 10° or less. The inclination angle θ1 is determined by the following method.

Firstly, a TEM is used to acquire a TEM image of the superconductive layer 30 in an arbitrary cross section of the superconductive layer 30 orthogonal to the main surface 20b. The TEM image is acquired at such a magnification (a first magnification) that at least 50 precipitates 40 are present in the field of view. Secondly, the inclination angle θ1 is measured for each of the plurality of precipitates 40 present in the field of view. In measuring the inclination angle θ1, the TEM image is magnified at a second magnification that is larger than the first magnification. Thus, if the inclination angle θ1 is 20° or less for all of the plurality of precipitates 40 present in the field of view, the relationship that "the inclination angle θ1 is 20° or less" is satisfied. The first magnification and the second magnification may be 50,000 times and 200,000 times, respectively.

In the cross-sectional view, both ends of the precipitate 40 in the longitudinal direction thereof are defined as an end 40a and an end 40b, respectively, and a tip portion of the end 40a in the longitudinal direction of the precipitate 40 is defined as a tip portion 40c, and a tip portion of the end 40b in the longitudinal direction of the precipitate 40 is defined as a tip portion 40d. The width W2 of the tip portion 40c in the direction orthogonal to the longitudinal direction of the precipitate 40 preferably becomes smaller toward the end 40a, and the width of the tip portion 40d in the direction orthogonal to the longitudinal direction of the precipitate 40 preferably becomes smaller toward the end 40b.

In the cross-sectional view, the precipitate 40 may have a protruding portion 40e between the end 40a and the end 40b. In the cross-sectional view, the protruding portion 40e protrudes along a direction orthogonal to the longitudinal direction of the precipitate 40.

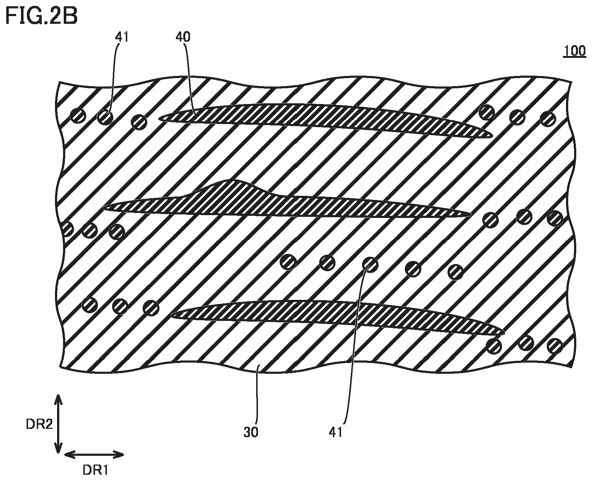

Fig. 2B is an enlarged view of a part in the vicinity of an end of the precipitate 40 in the longitudinal direction. As illustrated in Fig. 2B, precipitates 41 may be further dispersed in the superconductive layer 30. In the cross-sectional view, the precipitate 41 has a granular shape. In the cross-sectional view, the precipitate 41 may have, for example, a circular shape, an oval shape, a quadrangle shape (a square shape, a rectangular shape) with rounded corners, or a shape in which those shapes are distorted (sheared) in a specific direction in the cross-sectional view. The precipitates 41 are aligned along the longitudinal direction of the precipitate 40 in the vicinity of an end of the precipitate 40 in the longitudinal direction thereof or in parallel with the precipitate 40, for example. The constituent material of the precipitate 41 is a non-superconductive material (for example, metal oxide such as RE₂O₃ or BaMO₃). The minimum size of the precipitate 41 is, for example, 2 nm, and the maximum size of the precipitate 41 is about 16 nm.

### <First Modification>

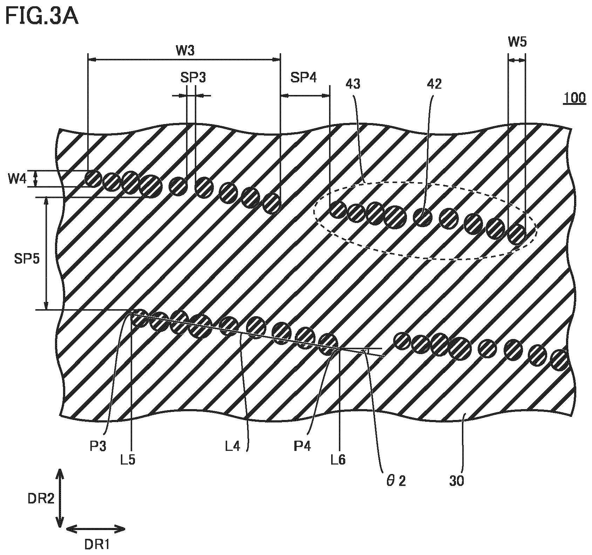

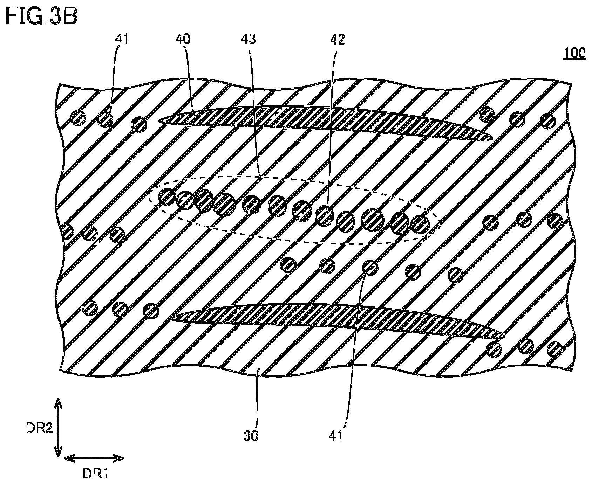

Fig. 3A is a first enlarged cross-sectional view of a superconductive wire 100 according to a first modification. Fig. 3B is a second enlarged cross-sectional view of the superconductive wire 100 according to the first modification. As illustrated in Fig. 3A, precipitates 42 may be dispersed in superconductive layer 30 instead of the precipitates 40. As illustrated in Fig. 3B, the precipitates 42 may be dispersed in the superconductive layer 30 together with the precipitates 40. The constituent material of the precipitate 42 is a non-superconductive material (for example, metal oxide such as RE₂O₃ or BaMO₃). The plurality of precipitates 42 are aligned in a row to form a group 43 in the cross-sectional view. There may be a plurality of groups 43 in the superconductive layer 30. The group 43 may include precipitates 42 in contact with each other. In other words, the group 43 may include two precipitates 42 having a spacing SP3 (which will be described later) of 0.

In the cross-sectional view, a direction in which the plurality of precipitates 42 are aligned in the group 43 is defined as an alignment direction. A spacing in the alignment direction between two adjacent precipitates 42 of the plurality of precipitates in the group 43 is defined as a spacing SP3. The maximum value of the spacing SP3 is, for example, 50 nm or less, 30 nm or less, 20 nm or less, 10 nm or less, or 5 nm or less. The spacing SP3 may be substantially equal to 0. In other words, two adjacent precipitates 42 may be aligned substantially in contact with each other. The maximum value of the spacing SP3 is, for example, 1/50 or less of a spacing SP4 which will be described later. The maximum value of the spacing SP3 is determined by the same method as the maximum value of the spacing SP1 and the maximum value of the spacing SP2.

In the cross-sectional view, the aspect ratio of the group 43 is obtained by dividing a width of the group 43 in the alignment direction by a width of the group 43 in the direction orthogonal to the alignment direction. The aspect ratio of the group 43 is 1 or more. The aspect ratio of the group 43 may be greater than 1. The aspect ratio of the group 43 is, for example, 3 or more or 5 or more. The aspect ratio of the precipitate 42 is obtained by dividing a width of the precipitate 42 in the longitudinal direction by a width of the precipitate 42 in the direction orthogonal to the longitudinal direction. The aspect ratio of the precipitate 42 may be, for example, 3 or less, 2 or less, or 1.5 or less. The precipitate 42 having an aspect ratio greater than 1 corresponds to the precipitate 40. The aspect ratio of the precipitate 42 may be 0.3 or more and 1 or less. The precipitate 42 having an aspect ratio smaller than 1 may constitute a protruding portion 43a to be described later. The aspect ratio of each of the plurality of precipitates 42 in the group 43 may be different from each other. The aspect ratio of the group 43 and the aspect ratio of the precipitate 42 are determined by the same method as the aspect ratio of the precipitate 40.

In the cross-sectional view, the width of the group 43 in the alignment direction thereof is defined as a width W3, the width of the group 43 in a direction orthogonal to the alignment direction thereof is defined as a width W4, and the width of the precipitate 42 in the alignment direction of the group 43 is defined as a width W5. The minimum value of the width W3 is, for example, 10 nm or more, 20 nm or more, or 30 nm or more. The maximum value of the width W3 is, for example, 10000 nm or less, 1700 nm or less, or 900 nm or less. The minimum value of the width W4 is, for example, 1 nm or more, 2 nm or more, or 3 nm or more. The maximum value of the width W4 is, for example, 200 nm or less, 150 nm or less, 100 nm or less, or 80 nm or less. The minimum value of the width W5 is, for example, 1 nm or more. The maximum value of the width W5 is, for example, 100 nm or less, 60 nm or less, or 40 nm or less.

An angle formed between the alignment direction and the main surface 20b in the cross-sectional view is defined as an inclination angle θ2. The alignment direction is defined as the direction of a straight line L4 which is defined as follows. Firstly, a straight line L5 and a straight line L6 are drawn. The straight line L5 and the straight line L6 are orthogonal to the main surface 20b and sandwich the group 43. An intersection point between the straight line L5 and the precipitate 42 at the first end of the group 43 is defined as an intersection point P3. An intersection point between the straight line L6 and the precipitate 42 at the second end (the end opposite to the first end) of the group 43 is defined as an intersection point P4. The straight line L4 is drawn to pass through the intersection point P3 and the intersection point P4. The inclination angle θ2 is 20° or less. The inclination angle θ2 is determined by the same method as the inclination angle θ1.

In the cross-sectional view, a spacing between two groups 43 adjacent to each other in the first direction DR1 is defined as a spacing SP4, and a spacing between two groups 43 adjacent to each other in the second direction DR2 is defined as a spacing SP5. The maximum value of the spacing SP4 is, for example, 2500 nm or less. The minimum value of the spacing SP4 is, for example, 2 nm or more. The maximum value of the spacing SP5 is, for example, 2000 nm or less. The minimum value of the spacing SP5 is, for example, 1 nm or more. The maximum value and the minimum value of the spacing SP4 are determined in the same manner as the maximum value and the minimum value of the spacing SP1, and the maximum value and the minimum value of the spacing SP5 are determined in the same manner as the maximum value and the minimum value of the spacing SP2.

### <Second Modification>

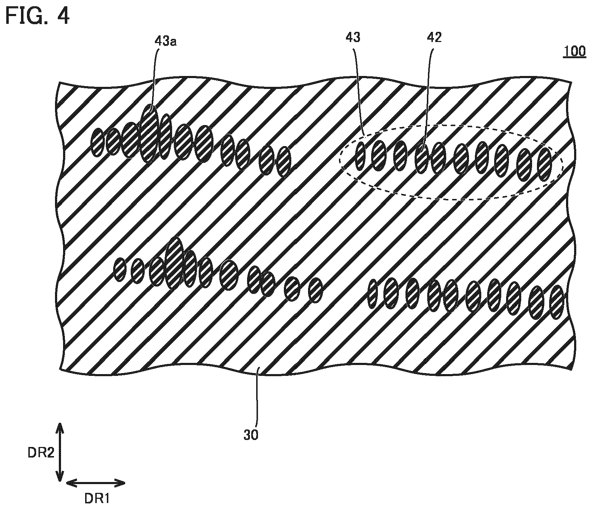

Fig. 4 is an enlarged cross-sectional view of a superconductive wire 100 according to a second modification. As illustrated in Fig. 4, in the cross-sectional view, the longitudinal direction of a precipitate 42 may intersect the alignment direction. The group 43 may have, between both ends thereof in the alignment direction, a protruding portion 43a that protrudes along a direction orthogonal to the alignment direction. The protruding portion 43a may be a part of the precipitates 42 in the group 43, and the aspect ratio of the precipitates 42 included in the part is smaller than the aspect ratio of the other precipitates 42 in the group.

### <Third Modification>

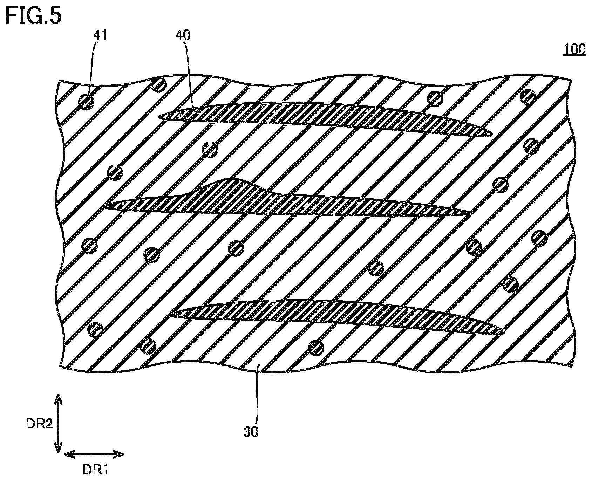

Fig. 5 is an enlarged cross-sectional view of a superconductive wire 100 according to a third modification. As illustrated in Fig. 5, the precipitates 41 are not aligned along the longitudinal direction of the precipitate 40, but are evenly dispersed throughout the superconductive layer 30.

### <Fourth Modification and Fifth Modification>

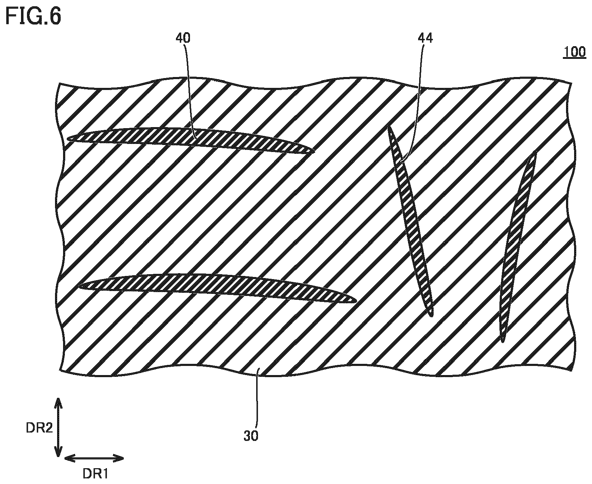

Fig. 6 is an enlarged cross-sectional view of a superconductive wire 100 according to a fourth modification. As illustrated in Fig. 6, precipitates 44 may be further dispersed in the superconductive layer 30. The constituent material of the precipitate 44 is a non-superconductive material (for example, metal oxide such as RE₂O₃ or BaMO₃). The aspect ratio of the precipitate 44 is obtained by dividing the width in the longitudinal direction of the precipitate 44 by the width in the direction orthogonal to the longitudinal direction of the precipitate 44 in the cross-sectional view. The aspect ratio of the precipitate 44 is greater than 1. The angle formed between the longitudinal direction of the precipitate 44 and the main surface 20b is, for example, 60° or more.

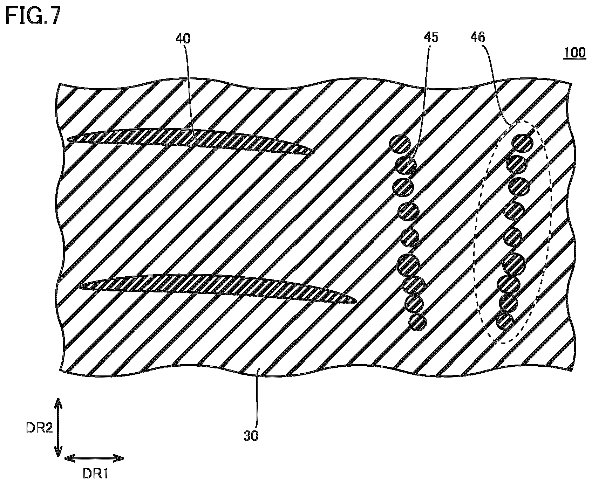

Fig. 7 is an enlarged cross-sectional view of a superconductive wire 100 according to a fifth modification. As illustrated in Fig. 7, a plurality of precipitates 45 may be further dispersed in the superconductive layer 30. The constituent material of the precipitate 45 is a non-superconductive material (for example, metal oxide such as RE₂O₃ or BaMO₃). The plurality of precipitates 45 are aligned in a row to form a group 46 in the cross-sectional view. The angle formed between the direction in which the precipitates 45 are aligned in the group 46 and the main surface 20b is 60° or more.

### <Method of Manufacturing Superconductive Wire 100>

Hereinafter, a method of manufacturing a superconductive wire 100 will be described.

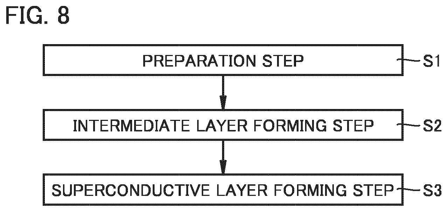

Fig. 8 is a process chart of manufacturing a superconductive wire 100. As illustrated in Fig. 8, the method of manufacturing a superconductive wire 100 includes a preparation step S1, an intermediate layer forming step S2, and a superconductive layer forming step S3. The intermediate layer forming step S2 is performed after the preparation step S1. The superconductive layer forming step S3 is performed after the intermediate layer forming step S2.

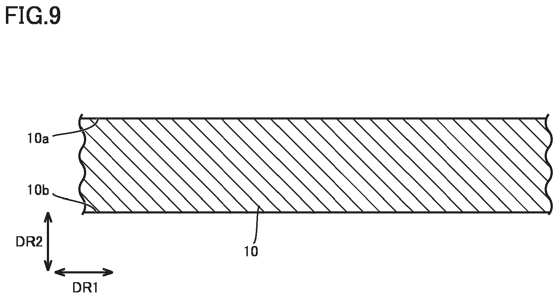

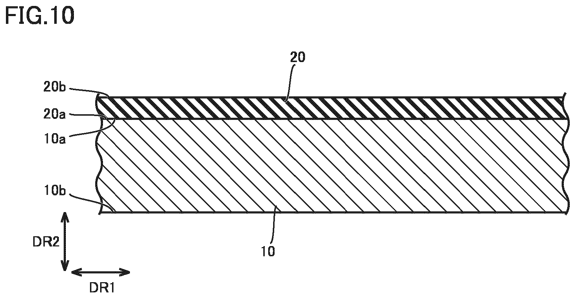

Fig. 9 is a cross-sectional view illustrating the preparation step S1. As illustrated in Fig. 9, in the preparation step S1, a substrate 10 is prepared. In the substrate 10 prepared in the preparation step S1, an intermediate layer 20 is not disposed on the main surface 10a. Fig. 10 is a cross-sectional view illustrating the intermediate layer forming step S2. As illustrated in Fig. 10, in the intermediate layer forming step S2, the intermediate layer 20 in which crystals are oriented is formed on the main surface 10a. The intermediate layer 20 is formed by sequentially forming each layer that constitutes the intermediate layer 20 by, for example, a magnetron sputtering method, an ion beam sputtering method, or a PLD (Pulsed Laser Deposition) method.

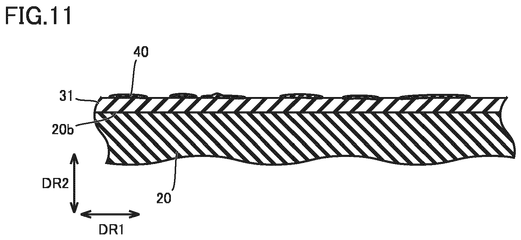

Fig. 11 is a cross-sectional view illustrating the superconductive layer forming step S3. As illustrated in Fig. 11, in the superconductive layer forming step S3, firstly, a superconductive layer 31 is formed on the intermediate layer 20. The superconductive layer 31 is thinner than the superconductive layer 30. The superconductive layer 31 is formed by, for example, a MOD (Metal Organic Decomposition) method, a MOCVD (Metal Organic Chemical Vapor Deposition) method, or a PLD method. During this process, the precipitates 40 are deposited on the surface or the inside of the superconductive layer 31 by shifting the rare earth element from the stoichiometric composition. Secondly, another superconductive layer 31 is formed on the already formed superconductive layer 31 in a similar manner. This process is repeated to form a plurality of superconductive layers 31 constituting the superconductive layer 30, and thereby, the superconductive wire 100 having the structure illustrated in Figs. 1 and 2A is manufactured.

The precipitates 40, the precipitates 41, and the precipitates 42 are deposited on the surface or the inside of the superconductive layer 31 by repeatedly stacking the superconductive layers in the superconductive layer forming step S3.

### <Effects of Superconductive Wire 100>

Hereinafter, the effects of the superconductive wire 100 will be described in comparison with comparative examples. A superconductive wire according to a first comparative example and a superconductive wire according to a second comparative example are defined as a superconductive wire 100A and a superconductive wire 100B, respectively.

The configuration of the superconductive wire 100A is different from the configuration of the superconductive wire 100 in that precipitates 40 are not dispersed in the superconductive layer 30. In the superconductive wire 100B, granular precipitates are dispersed in the superconductive layer 30. The precipitate is BaZr₂O₃ and functions as a magnetic flux pin. In this regard, the configuration of the superconductive wire 100B is different from the configuration of the superconductive wire 100.

Samples 1 to 6 were prepared as the superconductive wire samples. Sample 1 and Sample 2 correspond to the superconductive wire 100A and the superconductive wire 100B, respectively. Each of samples 3 to 6 correspond to the superconductive wire 100. In Samples 1 to 6, as shown in Table 1, the type of the precipitates (precipitate 40 as the first precipitate and precipitate 42 as the second precipitate), the aspect ratio of the precipitate 40, the average value of the aspect ratio of the precipitate 40, the inclination angle θ1 or the inclination angle θ2, the width W1 to the width W5, and the spacing SP1 to the spacing SP5 were changed. The numerical range in Table 1 shows the determination results of the widths or angles for 10 or more precipitates observed from the field of view set as described above. For example, the width W1 of Sample 4 was in the range of 10 nm or more and 350 nm or less. The average value of the inclination angle θ1, the inclination angle θ2, and the aspect ratio of the precipitate 40 is an average value for 10 or more precipitates. In Sample 1 and Sample 2, no precipitate was observed. In Sample 3, the precipitate 42 was observed, and in Sample 4, the precipitate 40 and the precipitate 42 were observed. In Sample 5, the precipitate 40 was observed. In Sample 6, the precipitate 42 was observed.

Although not shown in Table 1, in Sample 4, the group 43 of the precipitates 42 had a protruding portion 43a, and the precipitate 40 had a tip portion 40c (or a tip portion 40d), the width W2 of which becomes smaller toward the end 40a (or the end 40b), and the precipitate 41 was observed. In Sample 5, the precipitate 40 had a protruding portion 40e, and the precipitate 40 had a tip portion 40c (or a tip portion 40d), the width W2 of which becomes smaller toward the end 40a (the end 40b), and the precipitate 41 was observed. In Sample 6, the group 43 of the precipitates 42 had a protruding portion 43a.

### [Table 1]

**Table 1**

| Sample | Type of Precipitate | Precipitate 40 | | First Angle θ1 Second Angle θ2 (°) | Width W1 (nm) | Width W2 (nm) | Width W3 (nm) | Width W4 (nm) | Width W5 (nm) | Spacing SP1 (nm) | Spacing SP2 (nm) | Spacing SP3 (nm) | Spacing SP4 (nm) | Spacing SP5 (nm) |
|---|---|---|---|---|---|---|---|---|---|---|---|---|---|---|
| | | Aspect Ratio | Average Aspect Ratio | | | | | | | | | | | |
| 1 | - | - | - | - | - | - | - | - | - | - | - | - | - | - |
| 2 | - | - | - | - | - | - | - | - | - | - | - | - | - | - |
| 3 | precipitate 42 | - | - | 9.5 | - | - | 10-1700 | 1-60 | 1-100 | - | - | 1-15 | 15-230 | 1-290 |
| 4 | precipitate 40 | 11-46 | 20 | 6.7 | 10-350 | 0-90 | - | - | - | 8-1500 | 2-500 | - | - | - |
| | precipitate 42 | - | - | 9.3 | - | - | 30-10000 | 4-200 | 4-20 | - | - | 1-9 | 10-2500 | 16-2000 |
| 5 | precipitate 40 | 2-200 | 50 | 19 | 60-2000 | 4-200 | - | - | - | 10-330 | 10-160 | - | - | - |
| 6 | precipitate 42 | - | - | 7.3 | - | - | 40-900 | 3-15 | 1-10 | - | - | 1-50 | 2-900 | 5-210 |

For each sample, the superconductive properties were measured. In the measurement of the superconductive properties, Jc of each superconductive wire under a self-magnetic field at 77 K and Jc of each superconductive wire under a 3T magnetic field at 30 K were measured. The 3T magnetic field was applied in a direction perpendicular to the main surface 20b. Jc represents a critical current density. The measurement results are shown in Table 2. The value of α is calculated for each superconductive wire by dividing Jc measured under a 3T magnetic field at 30 K by Jc measured under a self-magnetic field at 77 K, and serves as an index of the low-temperature magnetic field property. The larger the value of α is, the better the low-temperature magnetic field property is. Jc was calculated from a critical current value (Ic) measured from each sample when the thickness of the superconductive layer 30 was 3±0.5 µm and the width of the superconductive layer 30 was 4 mm.

### [Table 2]

**Table 2**

| Sample | (1) Jc measured under a self-magnetic field at 77 K (MA/cm²) | (2) Jc measured under a 3T magnetic field at 30 K (MA/cm²) | a ((2)÷(1)) |
|---|---|---|---|
| 1 | 1.7 | 1.4 | 0.82 |
| 2 | 1.5 | 1.7 | 1.13 |
| 3 | 1.7 | 3.0 | 1.76 |
| 4 | 2.0 | 4.2 | 2.10 |
| 5 | 1.8 | 3.5 | 1.94 |
| 6 | 1.6 | 2.5 | 1.56 |

As shown in Table 2, the value of α for Samples 3 to 6 was larger than the value of α for Samples 1 and 2. In Samples 3 to 6, at least one of the following conditions was satisfied: (a) the aspect ratio of the precipitate 40 is greater than 1 and the inclination angle θ1 is 20° or less; and (b) the precipitates 42 are aligned in a row to form a group 43 and the inclination angle θ2 is 20° or less. From this comparison, it was experimentally evident that the low-temperature magnetic field property of the superconductive wire 100 is improved when conditions (a) and/or (b) are satisfied. The value of α was highest in sample 4 where both the precipitates 40 and the group 43 of the precipitates 42 were present in the superconductive layer 30. Therefore, it was experimentally evident that the low-temperature magnetic field property is further improved by the presence of both the precipitates 40 and the group 43 of the precipitates 42 in the superconductive layer 30.

It is considered that both ends of the precipitate 40 in the longitudinal direction function as magnetic flux pins for improving the low-temperature magnetic field property. Therefore, when the aspect ratio of the precipitate 40 becomes greater than 1, the portions functioning as the magnetic flux pins in the superconductive layer 30 can be regarded as being dispersed at intervals, and thereby the low-temperature magnetic field property of the superconductive wire 100 is improved as compared with the superconductive wire 100A and the superconductive wire 100B.

Since it is considered that the smaller the spacing SP1 is, the more likely for the precipitate 40 to function as a magnetic flux pin, by setting the maximum value of the spacing SP1 to 1500 nm or less, the low-temperature magnetic field property of the superconductive wire 100 is further improved. Since it is considered that the smaller the spacing SP2 is, the more likely for the precipitate 40 to function as a magnetic flux pin, by setting the maximum value of the spacing SP2 to 500 nm or less, the low-temperature magnetic field property of the superconductive wire 100 is further improved.

When the maximum value and the minimum value of the width W1 are 2000 nm or less and 10 nm or more, respectively, or when the maximum value and the minimum value of the width W2 are 200 nm or less and 1 nm or more, respectively, the portions of the precipitate 40 functioning as the magnetic flux pins are appropriately dispersed, and thereby the low-temperature magnetic field property of the superconductive wire 100 is further improved.

When the width of the tip portion 40c (or the tip portion 40d) in the direction orthogonal to the longitudinal direction of the precipitate 40 becomes smaller toward the end 40a (or the end 40b), it is considered that the tip portion 40c (or the tip portion 40d) is more likely to function as a magnetic flux pin, and thereby the low-temperature magnetic field property of the superconductive wire 100 is further improved.

When the precipitate 40 has a protruding portion 40e (the group 43 has a protruding portion 43a), it is considered that the protruding portion 40e (the protruding portion 43a) is more likely to function as a magnetic flux pin, and thereby the low-temperature magnetic field property of the superconductive wire 100 is further improved.

It should be understood that the embodiments disclosed herein have been presented for the purpose of illustration and description but not limited in all aspects. It is intended that the scope of the present invention is not limited to the description above but defined by the scope of the claims and encompasses all modifications equivalent in meaning and scope to the claims.

### REFERENCE SIGNS LIST

10: substrate; 10a, 10b: main surface; 20: intermediate layer; 20a, 20b: main surface; 30, 31: superconductive layer; 40: precipitate; 40a, 40b: end; 40c, 40d: tip portion; 40e: protruding portion; 41, 42: precipitate; 43: group; 43a: protruding portion; 44, 45: precipitate; 46: group; 100, 100A, 100B: superconductive wire; DR1: first direction; DR2: second direction; S1: preparation step; S2: intermediate layer forming step; S3: superconductive layer forming step; SP1, SP2, SP3, SP4, SP5: spacing; W1, W2, W3, W4, W5: Width; θ1: inclination angle; θ2: inclination angle.

## Claims

1. A superconductive wire (100) comprising:
a substrate (10);
an intermediate layer (20);
a superconductive layer (30); and
a plurality of first precipitates (40) and
a plurality of second precipitates (42),
wherein the substrate (10) has a first main surface (10a),
the intermediate layer (20) has a second main surface (20a) and a third main surface (20b) opposite to the second main surface (20a), and is disposed on the substrate (10) in such a manner that the second main surface (20a) faces the first main surface (10a),
the superconductive layer (30) is disposed on the third main surface (20b),
the constituent material of the superconductive layer (30) is REBa₂Cu₃Oₓ, wherein RE is a rare earth element,
the plurality of first precipitates (40) and the plurality of second precipitates (42) are dispersed in the superconductive layer (30),
the constituent material of each of the plurality of first precipitates (40) and the constituent material of each of the plurality of second precipitates (42) is a nonconductive material, in a cross-sectional view orthogonal to the third main surface (20b), the plurality of second precipitates (42) are aligned in a row to form a group (43) and an alignment direction of the plurality of second precipitates in the group (43) forms an angle (Θ2) of 20° or less with respect to the third main surface (20b); and **characterized**
**in that**, in the cross-sectional view, an aspect ratio of the width (W1) in a longitudinal direction (DR1) divided by the width (W2) in a direction orthogonal to the longitudinal direction (DR2) of each of the plurality of first precipitates is greater than 1 and in that, in the cross-sectional view, the longitudinal direction of each of the plurality of first precipitates forms an angle (θ1) of 20° or less with respect to the third main surface (20b).

2. The superconductive wire (100) according to claim 1, wherein
the constituent material of each of the plurality of first precipitates (40) is metal oxide.

3. The superconductive wire (100) according to claim 1 or claim 2, wherein
the constituent material of each of the plurality of first precipitates (40) is RE₂O₃ or BaMO₃, wherein M is a tetravalent metal element.

4. The superconductive wire (100) according to any one of claims 1 to 3, wherein
an average value of the aspect ratios of the width, W1, in the longitudinal direction and the width, W2, in the direction orthogonal to the longitudinal direction of the plurality of first precipitates (40) is 2 or more.

5. The superconductive wire (100) according to any one of claims 1 to 4, wherein
third precipitates (44) are further dispersed in the superconductive layer (30),
the constituent material of the third precipitate (44) is a non-superconductive material, and in the cross-sectional view, the third precipitate (44) has a granular shape.

6. The superconductive wire (100) according to any one of claims 1 to 5, wherein
in the cross-sectional view, a maximum value of a spacing in a direction parallel to the third main surface between two adjacent precipitates of the plurality of first precipitates in the direction parallel to the third main surface is 1500 nm or less.

7. The superconductive wire (100) according to any one of claims 1 to 6, wherein
in the cross-sectional view, a maximum value of a spacing, SP2, in a direction, DR2, orthogonal to the third main surface (20b) between two adjacent precipitates of the plurality of first precipitates (40) in the direction orthogonal to the third main surface (20b) is 500 nm or less.

8. The superconductive wire (100) according to any one of claims 1 to 7, wherein
in the cross-sectional view, a minimum value and a maximum value of the width, W1, of each of the plurality of first precipitates (40) in the longitudinal direction are 10 nm or more and 2000 nm or less, respectively.

9. The superconductive wire (100) according to any one of claims 1 to 8, wherein
in the cross-sectional view, a maximum value of the width, W2, of each of the plurality of first precipitates (40) in a direction orthogonal to the longitudinal direction is 200 nm or less.

10. The superconductive wire (100) according to any one of claims 1 to 9, wherein
in the cross-sectional view, at least one of the plurality of first precipitates (40) has, between both ends (40a, 40b) thereof in the longitudinal direction, a first protruding portion (40e) that protrudes along a direction orthogonal to the longitudinal direction, and
in the cross-sectional view, the group (43) has, between both ends thereof in the alignment direction, a second protruding portion (43a) that protrudes along a direction orthogonal to the alignment direction.

11. The superconductive wire (100) according to any one of claims 1 to 10, wherein
each of the plurality of first precipitates (40) has a tip portion (40c, 40d) at an end (40a, 40b) in the longitudinal direction, and the width, W2, of the tip portion (40c, 40d) in a direction orthogonal to the longitudinal direction becomes smaller toward the end (40a, 40b).

## Patentansprüche

1. Supraleitender Draht (100), umfassend:
ein Substrat (10);
eine Zwischenschicht (20);
eine supraleitende Schicht (30); sowie
eine Vielzahl erster Präzipitate (40) und
eine Vielzahl zweiter Präzipitate (42),
wobei das Substrat (10) eine erste Hauptfläche (10a) hat,
die Zwischenschicht (20) eine zweite Hauptfläche (20a) sowie eine der zweiten Hauptfläche (20a) gegenüberliegende dritte Hauptfläche hat und auf dem Substrat (10) so angeordnet ist, dass die zweite Hauptfläche (20a) der ersten Hauptfläche (10a) zugewandt ist,
die supraleitende Schicht (30) auf der dritten Hauptfläche (20b) angeordnet ist,
das Material, aus dem die supraleitende Schicht (30) besteht, REBa₂Cu₃Oₓ ist, wobei RE ein Seltenerdelement ist,
die Vielzahl erster Präzipitate (40) und die Vielzahl zweiter Präzipitate (42) in der supraleitenden Schicht (30) dispergiert sind,
das Material, aus dem jedes der Vielzahl erster Präzipitate (40) besteht, und das Material, aus dem jedes der Vielzahl zweiter Präzipitate (42) besteht, ein nichtleitendes Material ist, in einer Querschnittsansicht orthogonal zu der dritten Hauptfläche (20b) die Vielzahl zweiter Präzipitate (42) in einer Reihe ausgerichtet sind und eine Gruppe (43) bildet, und eine Richtung, in der die Vielzahl zweiter Präzipitate in der Gruppe (43) ausgerichtet sind, einen Winkel (θ2) von 20° oder weniger in Bezug auf die dritte Hauptfläche (20b) bildet, und
**dadurch gekennzeichnet, dass** in der Querschnittsansicht ein Aspektverhältnis der Breite (W1) in einer Längsrichtung (DR1), dividiert durch die Breite (W2) in einer Richtung orthogonal zu der Längsrichtung (DR2) jedes der Vielzahl erster Präzipitate größer ist als 1, sowie dadurch, dass in der Querschnittsansicht die Längsrichtung jedes der Vielzahl erster Präzipitate einen Winkel (θ1) von 20° oder weniger in Bezug auf die dritte Hauptfläche (20b) bildet.

2. Supraleitender Draht (100) nach Anspruch 1, wobei
das Material, aus dem jedes der Vielzahl erster Präzipitate (40) besteht, Metalloxid ist.

3. Supraleitender Draht (100) nach Anspruch 1 oder 2, wobei
das Material, aus dem jedes der Vielzahl erster Präzipitate (40) besteht, RE₂O₃ oder BaMO₃ ist, wobei M ein vierwertiges Metallelement ist.

4. Supraleitender Draht (100) nach einem der Ansprüche 1 bis 3, wobei ein Durchschnittswert der Aspektverhältnisse der Breite W1 in der Längsrichtung und der Breite W2 in der Richtung orthogonal zu der Längsrichtung der Vielzahl erster Präzipitate (40) 2 oder mehr beträgt.

5. Supraleitender Draht (100) nach einem der Ansprüche 1 bis 4, wobei
dritte Präzipitate (44) des Weiteren in der supraleitenden Schicht (30) dispergiert sind,
das Material, aus dem das dritte Präzipitat (44) besteht, ein nicht-supraleitendes Material ist, und
das dritte Präzipitat (44), in der Querschnittsansicht, eine granulare Form hat.

6. Supraleitender Draht (100) nach einem der Ansprüche 1 bis 5, wobei
ein Maximalwert eines Abstandes zwischen zwei benachbarten Präzipitaten der Vielzahl erster Präzipitate in einer Richtung parallel zu der dritten Hauptfläche, in der Querschnittsansicht, in der Richtung parallel zu der dritten Hauptfläche 1500 nm oder weniger beträgt.

7. Supraleitender Draht (100) nach einem der Ansprüche 1 bis 6, wobei, ein Maximalwert
eines Abstandes SP2 zwischen zweibenachbarten Präzipitaten der Vielzahl erster Präzipitate (40) in einer Richtung DR2 orthogonal zu der dritten Hauptfläche (20b), in der Querschnittsansicht in der Richtung orthogonal zu der dritten Hauptfläche (20b) 500 nm oder weniger beträgt.

8. Supraleitender Draht (100) nach einem der Ansprüche 1 bis 7, wobei
in der Querschnittsansicht ein Minimalwert und ein Maximalwert der Breite W1 jedes der Vielzahl erster Präzipitate (40) in der Längsrichtung 10 nm oder mehr bzw. 2000 nm oder weniger betragen.

9. Supraleitender Draht (100) nach einem der Ansprüche 1 bis 8, wobei
in der Querschnittsansicht ein Maximalwert der Breite W2 jedes der Vielzahl erster Präzipitate (40) in einer Richtung orthogonal zu der Längsrichtung 200 nm oder weniger beträgt.

10. Supraleitender Draht (100) nach einem der Ansprüche 1 bis 9, wobei
in der Querschnittsansicht wenigstens eines der Vielzahl erster Präzipitate (40) zwischen seinen beiden Enden (40a, 40b) in der Längsrichtung einen ersten vorstehenden Abschnitt (40e) aufweist, der in einer Richtung orthogonal zu der Längsrichtung vorsteht, und
in der Querschnittsansicht die Gruppe (43) zwischen ihren beiden Enden in der Richtung der Ausrichtung einen zweiten vorstehenden Abschnitt (43a) aufweist, der in einer Richtung orthogonal zu der Richtung der Ausrichtung vorsteht.

11. Supraleitender Draht (100) nach einem der Ansprüche 1 bis 10, wobei
jedes der Vielzahl erster Präzipitate (40) einen Spitzenabschnitt (40c, 40d) an einem Ende (40a, 40b) in der Längsrichtung hat, und die Breite W2 des Spitzenabschnitts (40c, 40d) in einer Richtung orthogonal zu der Längsrichtung zu dem Ende (40a, 40b) hin kleiner wird.

## Revendications

1. Fil supraconducteur (100) comprenant :
un substrat (10) ;
une couche intermédiaire (20) ;
une couche supraconductrice (30) ; et
une pluralité de premiers précipités (40) et une pluralité de deuxièmes précipités (42),
dans lequel le substrat (10) possède une première surface principale (10a),
la couche intermédiaire (20) possède une deuxième surface principale (20a) et une troisième surface principale (20b) à l'opposé de la deuxième surface principale (20a), et elle est disposée sur le substrat (10) d'une manière telle que la deuxième surface principale (20a) se trouve face à la première surface principale (10a),
la couche supraconductrice (30) est disposée sur la troisième surface principale (20b),
le matériau constitutif de la couche supraconductrice (30) est REBa₂Cu₃Oₓ, où RE est une terre rare,
la pluralité de premiers précipités (40) et la pluralité de deuxièmes précipités (42) sont dispersés dans la couche supraconductrice (30),
le matériau constitutif de chacun de la pluralité de premiers précipités (40) et le matériau constitutif de chacun de la pluralité de deuxièmes précipités (42) est un matériau non conducteur, dans une vue en coupe orthogonale à la troisième surface principale (20b), la pluralité de deuxièmes précipités (42) sont alignés suivant une ligne pour former un groupe (43) et une direction d'alignement de la pluralité de deuxièmes précipités dans le groupe (43) forme un angle (Θ2) de 20° ou moins par rapport à la troisième surface principale (20b) ; et **caractérisé en ce que**, dans la vue en coupe, un rapport d'aspect de la largeur (W1) dans une direction longitudinale (DR1) divisée par la largeur (W2) dans une direction orthogonale à la direction longitudinale (DR2) de chacun de la pluralité de premiers précipités est supérieur à 1 et **en ce que**, dans la vue en coupe, la direction longitudinale de chacun de la pluralité de premiers précipités forme un angle (θ1) de 20° ou moins par rapport à la troisième surface principale (20b).

2. Fil supraconducteur (100) selon la revendication 1, dans lequel
le matériau constitutif de chacun de la pluralité de premiers précipités (40) est un oxyde métallique.

3. Fil supraconducteur (100) selon la revendication 1 ou la revendication 2, dans lequel
le matériau constitutif de chacun de la pluralité de premiers précipités (40) est RE₂O₃ ou BaMO₃, où M est un élément métallique tétravalent.

4. Fil supraconducteur (100) selon l'une quelconque des revendications 1 à 3, dans lequel
une valeur moyenne des rapports d'aspect de la largeur, W1, dans la direction longitudinale et de la largeur, W2, dans la direction orthogonale à la direction longitudinale de la pluralité de premiers précipités (40) est égale à 2 ou plus.

5. Fil supraconducteur (100) selon l'une quelconque des revendications 1 à 4, dans lequel
des troisièmes précipités (44) sont également dispersés dans la couche supraconductrice (30),
le matériau constitutif du troisième précipité (44) est un matériau non supraconducteur, et
dans la vue en coupe, le troisième précipité (44) présente une forme granulaire.

6. Fil supraconducteur (100) selon l'une quelconque des revendications 1 à 5, dans lequel
dans la vue en coupe, une valeur maximale d'un espacement dans une direction parallèle à la troisième surface principale entre deux précipités adjacents de la pluralité de premiers précipités dans la direction parallèle à la troisième surface principale est égale à 1 500 nm ou moins.

7. Fil supraconducteur (100) selon l'une quelconque des revendications 1 à 6, dans lequel
dans la vue en coupe, une valeur maximale d'un espacement, SP2, dans une direction, DR2, orthogonale à la troisième surface principale (20b) entre deux précipités adjacents de la pluralité de premiers précipités (40) dans la direction orthogonale à la troisième surface principale (20b) est égale à 500 nm ou moins.

8. Fil supraconducteur (100) selon l'une quelconque des revendications 1 à 7, dans lequel
dans la vue en coupe, une valeur minimale et une valeur maximale de la largeur, W1, de chacun de la pluralité de premiers précipités (40) dans la direction longitudinale sont respectivement égales à 10 nm ou plus et 2 000 nm ou moins.

9. Fil supraconducteur (100) selon l'une quelconque des revendications 1 à 8, dans lequel
dans la vue en coupe, une valeur maximale de la largeur, W2, de chacun de la pluralité de premiers précipités (40) dans une direction orthogonale à la direction longitudinale est égale à 200 nm ou moins.

10. Fil supraconducteur (100) selon l'une quelconque des revendications 1 à 9, dans lequel
dans la vue en coupe, l'un au moins parmi la pluralité de premiers précipités (40) possède, entre deux extrémités (40a, 40b) de celui-ci dans la direction longitudinale, une première partie saillante (40e) qui fait saillie le long d'une direction orthogonale à la direction longitudinale, et
dans la vue en coupe, le groupe (43) possède, entre deux extrémités de celui-ci dans la direction d'alignement, une seconde partie saillante (43a) qui fait saillie le long d'une direction orthogonale à la direction d'alignement.

11. Fil supraconducteur (100) selon l'une quelconque des revendications 1 à 10, dans lequel
chacun de la pluralité de premiers précipités (40) possède une partie en pointe (40c, 40d) au niveau d'une extrémité (40a, 40b) dans la direction longitudinale, et la largeur, W2, de la partie en pointe (40c, 40d) dans une direction orthogonale à la direction longitudinale diminue en allant vers l'extrémité (40a, 40b).
